# EUROPEAN PATENT SPECIFICATION

(11) **EP 0 454 335 B1**
(45) Date of publication and mention of the grant of the patent: **17.07.1996**
(21) Application number: 91303327.0
(22) Date of filing: 16.04.1991
(51) Int. Cl.: G03F 7/039, C08L 33/06

(54) **Photoresist composition**
Photoresistzusammensetzung
Composition de photoréserves

(30) Priority: 24.04.1990 US 513652
(43) Date of publication of application: 30.10.1991
(73) Proprietor: International Business Machines Corporation, Armonk, N.Y. 10504 (US)
(72) Inventor: Allen, Robert David, San Jose, California 95120 (US); Wallraff, Gregory Michael, San Jose, California 95123 (US); Simpson, Logan Lloyd, Austin, Texas 78750 (US); Hinsberg, William Dinan III, Fremont, California 94539 (US)
(74) Representative: Burt, Roger James, Dr.

(56) References cited:
- EP-A- 0 330 059
- US-A- 4 491 628
- US-A- 4 629 680

## Description

The present invention relates generally to photoresist compositions and particularly to dry film, aqueous processable photoresist compositions, for use, for example in the production of printeed circuits.

As the packing density of printed circuits increases, the need for higher resolution is a continuing driving force in the development of new photoresist materials. The "RISTON" family of dry film photoresists are widely utilized in circuit board fabrication. These materials are based on photoinitiated free-radical polymerization of multifunctional monomers, leading to insolubilization of the exposed areas via cross-linking. Such resists exhibit high sensitivity due to the nature of the polymerization wherein many covalent bonds are produced for each radical generated. However, the tendency toward swelling during development, the requirement for an oxygen impermeable cover sheet during the exposure step, and resolution limitations are all drawbacks which are intrinsic to this resist chemistry.

Resist systems based on acid-catalyzed chain reactions (e.g., polymerization, depolymerization, side chain cleavage, etc.) have been proposed, for example in microlithography. Such systems are described in, Polymers in Electronics, Davidson T. Ed., ACS Symposium Series 242, American Chemical Society, Washington, D.C., 1984, p.11, H. Ito, C.G. Willson. These systems offer high sensitivity due to a mechanism known as chemical amplification, while avoiding many of the drawbacks of free-radical based systems.

We have found that a particular family of photoresist compositions exploiting the mechanism of acid-catalyzed chemical amplification offers marked advantages in printed circuit board manufacture, not only in terms of resolution, but also in their capability of imaging at a selected wavelength, thermal properties for dry film applications, and aqueous processibility.

According to the invention we provide a photoresist composition having a characteristic glass temperature and which operates by the mechanism of acid catalyzed chemistry, comprising
(A) a film forming polymer binder, the polymer chain of said polymer binder comprising the following polymerizable units:
   a first monomer which contributes acid sensitive groups pendant on the polymer backbone, the first monomer being selected from the group consisting of tertiary butyl acrylate and tertiary butyl methacrylate,
   a second monomer class selected from the group consisting of alkyl methacrylates, alkyl acrylates and combinations thereof, the second monomer class being present in an amount effective to lower the glass temperature of the resist composition below about 90°C, and
   a third monomer selected from the group consisting of carboxylic acids of acrylates and carboxylic acids of methacrylates,
(B) an initiator which gernerates acid upon exposure to radiation.

The dry film photosensitive resist compositions of the invention are adapted for hot roll lamination to a substrate at a selected lamination temperature and also operate by the mechanism of acid catalyzed chemistry. The first monomer is preferably selected from the group consisting of tertiary butyl methacrylate and tertiary butyl acrylate. The second monomer is most preferably methyl methacrylate, ethyl acrylate, and combinations thereof, and the third monomer is most preferably acrylic acid. Preferably, the ethyl acrylate is present in an amount effective to lower the glass temperature of the resist composition in the range from about 30 to 50 degrees below the selected hot roll lamination temperature.

### DETAILED DESCRIPTION OF THE PREFERRED EMBODIMENT

The photoresist compositions of the invention include a film forming polymer binder. The binder is an acrylic polymer which includes acid-labile side groups which react with a selected photoacid generator in a chemical amplification reaction to produce positive photoresists.

The acrylic polymer which makes up the film forming binder includes a first monomer which contributes the acid sensitive groups pendant on the polymer backbone. The preferred acid labile pendant groups are t-butyl esters of carboxylc acids and t-butyl carbonates of phenols but, it is understood that a wide range of acid labile groups are operative in the invention. For instance, additional acid sensitive groups are listed in U.S. Patent No. 4,491,628, "Positive- And Negative-Working Resist Compositions With Acid Generating Photoinitiator and Polymer With Acid-Labile Groups Pendant From Polymer Backbone" Preferred acid sensitive groups useful in the practice of the present invention include the t-butyl esters of acrylates and methacrylates.

The first monomer is preferably present in the polymer binder in the range from about 10 to 50% by weight based on the sum of all polymerizable units present.

The second class of monomer used to produce the polymeric binder is selected from the group consisting of alkyl methacrylates, alkyl acrylates and combinations thereof, e.g. methyl methacrylate (MMA) or ethyl methacrylate, ethyl acrylate (EA) or butyl acrylate. The most preferred second monomers are methyl methacrylate and/or ethyl acrylate. The choice of monomer or monomers which make up the second monomer class is dependent, at least in part, upon the glass temperature (Tg) requirement of the polymer binder which differs dependent upon whether the composition will be liquid or dry-film applied. The second monomer class is present in the polymer binder in the range of 30-70% by weight based on the sum of all polymerizable units present.

The third monomer is preferably selected from the group consisting of carboxylic acids of acrylates and carboxylic acids of methacrylates, e.g., acrylic acid and methacrylic acid. The choice of third monomer is also influenced by the glass temperature (Tg) requirements of the polymer binder, as will be explained. The third monomer is preferably present in the polymer in the range from about 5 to 30% by weight, based on the sum of all polymerized units present.

The preparation of polymers falling within the above described classes will be familiar to those skilled in the art, since they are readily prepared using known techniques. For instance, methacrylate and acrylate homo-,co-,ter-, tetra-, etc., polymers are synthesized by free radical solution polymerization. The choice of polymerization solvent is governed by factors such as solubility of the monomers, the nature of the initiators and formed polymer, boiling point, cost, etc. A variety of azo and peroxide initiators can be used to initiate the polymerization. In a typical synthesis, a reactor is charged with solvent (THF, MEK, etc.) and the desired monomers such that the formed polymer, assuming 100% conversion, attains a final concentration of 10 to 50% (wt/wt). The initiator is then charged (typically AIBN or BPO), at levels from 0.05% to 1.0% (vs. monomer), depending on the desired molecular weight. The system is sparged with nitrogen to remove oxygen. The polymerization is typically run at 60 to 80 degrees centigrade for 10 to 24 hours. The polymer is isolated by precipitation into a nonsolvent (hydrocarbon or water), and collected and dried at elevated temperatures under vacuum.

The initiator or photoacid generator used in the photosensitive resist compositions of the invention produce strong acids upon exposure to radiation. They are described in the literature and include, depending upon the exposure technology, aryldiazonium, diaryliodonium and triarylsulfonium metal halides. Other photoacid generators are described, e.g., in U.S. Patent No. 4,250,053, "Sensitized Aromatic Iodonium or Aromatic Sulfonium Salt Photoinitiator Systems", issued February 10, 1981, to George H. Smith, the disclosure of which is incoporated herein by reference. Nonionic photoacid generators are also well known, and are described in the art. The photoacid generator is preferably present in the polymer binder in the range from about 1 to 20 w/w% to polymer.

The photoresist compositions of the invention can also contain a sensitizer capable of sensitizing the photoacid generator to longer wavelengths ranging from mid UV to visible light. Depending upon the intended application, such sensitizers include polycyclic aromatics such as pyrene and perylene. The sensitization of the photoacid generators is well known and has been described in United States Patent No. 4,250,053, cited earlier and in United States Patent No. 4,371,605. A preferred sensitizer useful in sensitizing the photoresist compositions of the invention for visible light or laser direct imageable photoresists is described in the copending European application No 90313654.7. The invention is not limited to the use of a particular class of sensitizer or photoacid generator, however.

The novel film forming polymer binder and selected photoacid generator provide a photoresist composition which is well suited for use in imaging processes utilizing the imaging mechanism known as "chemical amplification." The methacrylate terpolymers used as the acid-labile binder provide tough, film-forming characteristics, while the "chemical amplification" mechanism (involving onium salt photolysis, acid generation, and side-group deprotection) is unique in its ability to afford a combination of high photospeed, high contrast, and oxygen insensitivity. Chemical amplification is described, e.g., in USP 4,491,628, previously cited.

The polymer materials selected from the first, second and third monomer classes described above, and which are used in the resists of the invention, have properties which make them uniquely suited as photoresists. The t-butyl ester monomer contributes the acid sensitive groups which form the basis of the acid catalyzed deprotection mechanism. The acrylate/methacrylate monomer increases the toughness of the film, while the acrylic acid/methacrylic acid monomer helps to control the development rate of the exposed resist.

Thus, the above stated monomers each fill a vital role in the makeup of the resin system. The t-butyl ester monomer (e.g. t-butyl methacrylate) (TBMA) imparts acid sensitivity to the polymer, i.e., photogenerated acid can react with side groups in the polymer chain to render them soluble in an aqueous base developer. However, a simple poly(t-butyl methacrylate) homopolymer is inadequate for circuitization applications, due to its cost, poor mechanical properties, incompatibility toward a variety of common acid generators. A much more desirable resin is produced through copolymerization with methyl methylacrylate and/or ethyl acrylate. Copolymerization with this "non-active" monomer leads to dramatic increase in mechanical properties and cost performance. In addition, the increase in solubility of most common photoinitiators in the polymer film leads to an unanticipated increase in photospeed. These copolymers are excellent imaging materials when formulated with photo-acid producing compounds. Their only limitation is the lack of processibility in fully aqueous developers (e.g. aqueous sodium carbonate). The addition of a third monomer is critical in achieving the desired developability. Methacrylic acid and/or acrylic acid is terpolymerized with the above two monomers. A compositional window exists whereby fairly rapid get practical development rates in exposed areas exists, but the unexposed film exhibits no developer attack. It was anticipated that this addition of acidic monomer would lead to a loss of contrast, but within the boundaries of this relatively wide window, contrast is excellent. These terpolymers are synergistic materials which combine aqueous developability, good mechanical properties, low cost, excellent adhesion, and excellent contrast to lead to outstanding resolution capabilities.

These terpolymers exhibit excellent development characteristics, similar to those commonly found in high resolution novolak-based photoresists. An initial induction period, followed by a second stage
f rapid development is common to both classes of materials, leading to high contrast, and thus, resolution.

However, in addition to the resist requirements of photospeed, contrast, resolution, aqueous developability and oxygen insensitivity, in the design of a dry film material consideration must also be given to the thermal properties of the resist. Hot-roll lamination temperatures of 100°C to 120°C are desirable for resist applications. Experience dictates that glass temperatures (Tg) of the resist composition should be from about 30 to 50 degrees below the desired lamination temperature. The materials described above form excellent films when coated on Mylar, are tough and flexible, not prone to cracking, or physical delamination. However, due to the intrinsically high Tg of the methacrylic acid-containing materials, useful imaging materials have high glass temperatures, and correspondingly excessive transfer (lamination) temperatures, at or near the decomposition temperature of the resist.

Thus, to lower the Tg of the resin without degrading the aqueous development characteristics, it is preferred to substitute acrylic monomers for methacrylic monomers in the dry film material, thereby lowering the glass temperature of the resist composition below about 90°C. For example, simply replacing methacrylic acid (MAA) with acrylic acid (AA) lowers the Tg of a typical resist from 30 to 40 degrees while keeping the desirable imaging characteristics.

The following example is intended to be illustrative of the invention:

### EXAMPLE

The photosensitive materials which resulted from the tetrapolymerization of EA with MMA, TBMA, and AA are well adapted for use as dry film photoresists. For example, a dry-film resist containing an EA-MMA-TBMA-AA tetrapolymer binder of composition 0.75/0.75/1.0/.035 (weight ratio) showed excellent imaging characteristics, formed tough films, had a Tg of 83°C, and transferred to copper at 120°C. The dry film tetrapolymer exhibits tremendous versatility, as demonstrated by spinning the formulated material (from solution with 10% diphenyl iodonium hexafluoroantimonate) onto Mylar to give a 1.0 m film. The dry film resist was then transferred onto a silicon wafer (100°C, thumb pressure) and imagewise exposed at 254 nm. Resolution patterns of 2 m spaces were opened after development. This experiment was successfully repeated with e-beam exposure, this time opening 1.0 m gaps in a 1.0 m film at a dose of 5.0 C/cm².

An invention has been provided with several advantages. The materials of the invention are tough, film-forming, capable of acid-catalyzed deprotection chemistry, high resolution imaging and are developable in sodium carbonate/water. Specially tailored properties can be "tuned" to an unanticipated extent by adjusting both the monomer ratios and molecular weight. Thus, TBMA provide the acid sensitivity which is the basis of a chemically amplified resist. The non-active monomer (MMA) gives improved mecharnical properties and increases the solubility of the photoacid generator in the terpolymer binder without degrading the photospeed. A third monomer (MAA), acts to alter the development rate of the exposed resist, without affecting the contrast, i.e., the unexposed resist remains inert to the developer. The ethyl acrylate lowers the glass temperature of the resist composition, making it well suited for hot roll lamination as a dry film.

## Claims

1. A photoresist composition having a characteristic glass temperature and which operates by the mechanism of acid catalyzed chemistry, comprising
(A) a film forming polymer binder, the polymer chain of said polymer binder comprising the following polymerizable units:
a first monomer which contributes acid sensitive groups pendant on the polymer backbone, the first monomer being selected from the group consisting of tertiary butyl acrylate and tertiary butyl methacrylate,
a second monomer class selected from the group consisting of alkyl methacrylates, alkyl acrylates and combinations thereof, the second monomer class being present in an amount effective to lower the glass temperature of the resist composition below about 90°C, and
a third monomer selected from the group consisting of carboxylic acids of acrylates and carboxylic acids of methacrylates,
(B) an initiator which generates acid upon exposure to radiation.

2. A composition as claimed in claim 1, wherein the second monomer is selected from the group consisting of methyl methacrylate, ethyl acrylate and combinations thereof.

3. A composition as claimed in claim 1 or claim 2, wherein the third monomer is acrylic or methacrylic acid.

4. A composition as claimed in any of claims 1 to 3, wherein the polymer binder comprises approximatly 10 to 50% by weight t-butyl methacrylate, 5 to 20% by weight acrylic acid and 30 to 70% by weight of a mixture of ethyl acrylate and methyl methacrylate.

## Patentansprüche

1. Eine Photoresist-Zusammensetzung mit einer charakteristischen Glasübergangstemperatur, die nach dem Mechanismus der säurehärtenden Chemie arbeitet, und der enthält:
(A) Einen schichtausbildenden Polymerbinder, wobei die Polymerkette des Polymerbinders die folgenden polymerisierbaren Einheiten umfaßt:
ein erstes Monomer, das säureempfindliche Gruppen beisteuert, die sich an das Polymerrückgrat hängen, wobei der das erste Monomere gewählt wird aus der Gruppe, die aus tertiärem Butylacrylat und tertiärem Butylmethacrylat besteht,
eine zweite Monomerklasse, gewählt aus der Gruppe Alkylmethacrylat, Alkylacrylate und Kombinationen daraus,
wobei die zweite Monomerklasse in einen Menge vorkommt, die wirksam ist, die Glasübergangstemperatur der Resistzusammensetzung auf unter etwa 90°C zu senken, und
ein drittes Monomer aus der Gruppe Acrylat-Carbonsäuren und Methacrylat-Carbonsäuren gewählt wird,
(B) ein Initiator, der bei Belichtung durch eine Strahlung Säure erzeugt.

2. Eine Zusammensetzung gemäß Anspruch 1, in der das zweite Monomer aus der Gruppe Methylmethacrylat, Ethylmethacrylat und Kombinationen derselben ausgewählt wird.

3. Eine Zusammensetzung gemäß Anspruch 1 oder Anspruch 2, in der das dritte Monomer Acrylsäure oder Methacrylsäure ist.

4. Eine Zusammensetzung gemäß einem beliebigen der Ansprüche 1 bis 3, in der der Polymerbinder etwa 10 bis 50 Gewichtsprozent t-Butylmethacrylat, 5 bis 25 Gewichtsprozent Acrylsäure, und 30 bis 70 Gewichtsprozent eines Gemischs aus Ethylacrylat und Methylmethacrylat enthält.

## Revendications

1. Composition de photorésist ayant une température de verre caractéristique et dont le principe de fonctionnement est basé sur la mécanique de la chimie par catalyse acide, comprenant :
(A) un premier liant polymère filmogène, la chaîne polymère du dit liant polymère comprenant les unités polymérisables suivantes :
un premier monomère qui contribue aux groupes sensibles à l'acide suspendus à l'épine dorsale polymère, le premier monomère étant choisi parmi le groupe composé de l'acrylate de butyle tertiaire et du méthacrylate de butyle tertiaire ;
un deuxième classe de monomères choisie parmi le groupe comprenant les méthacrylates d'alkyle, les acrylates d'alkyle et des combinaisons de ceux-ci, la deuxième classe de monomères étant présente en une quantité qui permet d'abaisser efficacement la température de verre de la composition de résist sous 90°C environ ; et
un troisième monomère choisi parmi le groupe comprenant des acides carboxyliques d'acrylates et des acides carboxyliques de méthacrylates ; et
(B) un initiateur qui génère de l'acide sous exposition au rayonnement.

2. Composition selon la revendication 1, dans laquelle le deuxième monomère est choisi parmi le groupe composé du méthacrylate de méthyle, de l'acrylate d'éthyle et de combinaisons de ceux-ci.

3. Composition selon la revendication 1 ou 2, dans laquelle le troisième monomère est de l'acide acrylique ou méthacrylique.

4. Composition selon l'une quelconque des revendications 1 à 3, dans laquelle le liant polymère est composé d'environ 10 à 50% en pourcentage de poids de méthacrylate de t-butyle, de 5 à 20% en pourcentage de poids d'acide acrylique et de 30 à 70% en pourcentage de poids d'un mélange d'acrylate d'éthyle et de méthacrylate de méthyle.
